Europäisches Patentamt

European Patent Office

Office européen des brevets

(11) Veröffentlichungsnummer: **0 006 504**
B1

(12) **EUROPÄISCHE PATENTSCHRIFT**

(45) Veröffentlichungstag der Patentschrift: 07.04.82

(51) Int. Cl.³: **G 03 C 7/00**, G 03 F 3/04, G 03 F 3/08

(21) Anmeldenummer: 79101824.5

(22) Anmeldetag: 08.06.79

(54) **Farbauszugstransparent und Verfahren zu seiner Herstellung.**

(30) Priorität: 16.06.78 DE 2826380

(43) Veröffentlichungstag der Anmeldung:
09.01.80 Patentblatt 80/1

(45) Bekanntmachung des Hinweises auf die Patenterteilung:
07.04.82 Patentblatt 82/14

(84) Benannte Vertragsstaaten:
DE FR GB IT NL

(56) Entgegenhaltungen:
EP - A - 0 002 043
DE - A - 2 703 160
DE - B - 1 921 460
DE - B - 2 657 246
DE - B - 2 734 580
DE - B - 2 734 581
DE - C - 940 622
US - A - 2 123 830
US - A - 4 057 326

(73) Patentinhaber: HOECHST AKTIENGESELLSCHAFT
Postfach 80 03 20
D-6230 Frankfurt/Main 80 (DE)

(72) Erfinder: Moraw, Roland, Dr.
Buchenweg 4
D-6200 Wiesbaden-Naurod (DE)

(56) Entgegenhaltungen:
SIEMENS ZEITSCHRIFT, Jahrgang 49, Heft 8,
1975, Erlangen, DE,
E. HENNIG: "Chromagraph DC 300 zum
Herstellen von Farbauszügen für die
Druckindustrie", Seiten 522—527

# 0 006 504

## Farbauszugstransparent und Verfahren zu seiner Herstellung

Die Erfindung betrifft ein Farbauszugstransparent für eine bestimmte, aus den Primärfarben blau, grün, gelb, rot, bzw. den Farben weiß und schwarz oder den Mischfarben ausgewählte Farbe, sowie Verfahren zu seiner Herstellung.

Derartige Farbauszugstransparente werden für die Herstellung von Reliefstrukturen in der Ebene eines Aufzeichnungsmaterials verwendet, von dem Prägematrizen abgenommen werden, mit denen z.B. Reliefbilder in Polyvinylchloridfolien geprägt werden, die bei der Projektion ein buntes Bild der Vorlage für die Farbauszüge ergeben.

Mit der aus der Zeitschrift LASER u. Elektro-Optik Nr. 3/1976, Seiten 16/17 bekannten ZOD-Technik (Zero-Order-Diffraction) werden gittermäßig gerasterte Bilder erzeugt. Von den Reliefbildern, die beispielsweise drei Grundfarbengittermustern in drei Fotolackschichten entsprechen, werden drei Nickelmatrizen hergestellt, mit denen farblose thermoplastische Folien aus Polyvinylchlorid geprägt werden. Diese Folien werden mechanisch überlagert. Bei der Projektion der überlagerten Prägebilder mit konventionellen Projektoren werden von den farblosen Reliefbildern farbige Projektionsbilder erhalten. Die gitterförmige Strukturierung erfolgt mit Reliefgittern von rechteckförmigem Querschnitt, wobei die Gitterperiode etwa 1,5 $\mu$m beträgt. Für jeden Farbauszug in gelb, magenta und cyan mit Relieftiefen von etwa 1,2 $\mu$m, 1,5 $\mu$m and 1,8 $\mu$m wird je eine Nickelmatrize mit unterschiedlicher Relieftiefe erstellt, mit der die getrennten Prägebilder erzeugt werden. Die Prägebilder werden zu einem dreischichtigen Reliefbild überlagert, von dem farbige Bilder projiziert werden können.

Ein Nachteil, der die Einführung dieser Technik erschwert, ist der aufwendige Herstellungsprozeß mit drei vollständig getrennten Arbeitsgängen zur Herstellung der einzelnen, den Farbauszügen entsprechenden geprägten Reliefgitter. Ein weiterer, schwerwiegender Nachteil ist das erforderliche, paßgerechte Zusammensetzen der drei getrennten Reliefbilder zu dem für die farbige Projektion erforderlichen Duplikatbild.

In der DE—A—26 57 246 wird zur Behebung dieses Nachteils vorgeschlagen, das Reliefbild aus mehreren überlappungsfrei aneinander grenzenden Relief-Teilbildern unterschiedlicher Gittertiefen in einer Ebene zusammenzusetzen. Die weitere Ausgestaltung dieser Technik ist in der DE—A—27 34 581 beschrieben, nach der Gitter-strukturen für weinigstens vier Projektionsfarben z. B. gelb, rot, blau-violett und grün angewendet werden. Die Farbe weiß wird durch gitterfreie Teilbereiche dargestellt. Für schwarze Teilbilder wurde eine Herstellung durch statistisch unregelmäßige Relief-strukturen von 1—2 $\mu$m Tiefe vorgeschlagen.

In der DE—A—27 34 580 ist beschrieben, zur Erzeugung derartiger Reliefbilder in einer Ebene die Fotolackschicht gittermäßig bis zur größten Gittertiefe für die Projektionsfarbe grün auszubelichten und dann durch Belichtung durch Farbauszüge hindurch die Gittertiefen der Teilbilder bis auf die für die jeweils gewünschte Projektionsfarbe rot, gelb, blau oder weiß notwendigen Tiefen abzubauen. Für die Farbe weiß muß der Gitterstruktur nahezu zur Gänze entfernt werden. Die grünen Teilbildbereiche werden nicht nachbelichtet, da die größte Gittertiefe, wie voranstehend erwähnt ist, für die Projektionsfarbe grün bereits ausbelichtet wurde.

Aufgabe der Erfindung ist es, Farbauszüge für die gittermäßige Belichtung einer Aufzeichnungsschicht mit mehreren Projektionsfarben zu schaffen sowie ein Verfahren zur Herstellung von solchen Farbauszügen anzugeben.

Diese Aufgabe wird erfindungsgemäß dadurch gelöst, daß ein Teilbild in der jeweiligen gewählten Farbe vorhanden ist, daß das Farbauszugstransparent in den Flächenbereichen transparent ist, welche die ausgewählte Fare wiedergeben, daß die außerhalb des Teilbildes liegenden Flächen des Farbauszugstransparents opak sind, und daß das Teilbild derart gerastert ist, daß es eine Anzahl von Rasterelementen aufweist, deren mittlerer Abstand voneinander in jedem Bildbereich der mittleren Farbdichte in diesem Bildbereich entspricht.

Es müssen somit die einzelnen transparenten Farbauszüge für grün, rot, gelb, blau, sowie für weiß und schwarz so aufeinander abgestimmt sein, daß sie folgende zwei Bedingungen erfüllen: Bei jeweils paarweiser Superposition von Farbauszügen muß vollständige Opazität auftreten, bei Superposition aller Farbauszüge in zeitlicher Folge muß vollständige Transparenz auftreten. Die weitere Ausgestaltung der Erfindung sowie verschiedene Herstellungsverfahren für derartige Farbauszüge, insbesondere für gerasterte Farbauszüge mit einer Rasterfolie mit mehrfacher Periodizität, sind aus den kennzeichnenden Merkmalen der Patentansprüche 2 bis 15 ersichtlich.

Die Erfindung wird im folgenden unter Bezugnahme auf die Zeichnungen näher erläutert.

Es zeigen:

Fig. 1a eine schematische, graphische Darstellung einer Vorlage, die mehrere Grundfarben enthält,

Fig. 1b bis 1g Farbauszüge für die einzelnen Grundfarben der Vorlage nach Fig. 1a, Fig. 2a eine Vorlage mit einer Abnahme der Farbintensität von oben nach unten,

Fig. 2b das zur Vorlage nach Fig. 2a gehörende Farbauszungsnegativ,

Fig. 3a vier Rasterfolien mit jeweils voneinander verschiedenen Dichten,

Fig. 3b eine aus den vier Rasterfolien nach Fig. 3a unter Versetzung um Bruchteile einer Raster-

2

**0 006 504**

periode durch Aufkopieren auf ein Aufzeichnungsmaterial entstandene Rasterfolie,

Fig. 3c die optische Dichte längs des Streckenzugs A—B—C—D in Fig. 3b,

Fig. 4a eine prinzipielle Anordnung zur Gewinnung von Farbauszügen mit Hilfe der Rasterfolie nach Fig. 3b,

Fig. 4b eine schematische Darstellung der zyklischen Versetzung der Vorlage in einer geschlossenen Bahn,

Fig. 5a zwei gerasterte Farbauszüge für einen Farbübergang zwischen zwei Farben, und

Fig. 5b ein Rastermuster auf einer Aufzeichnungsschicht.

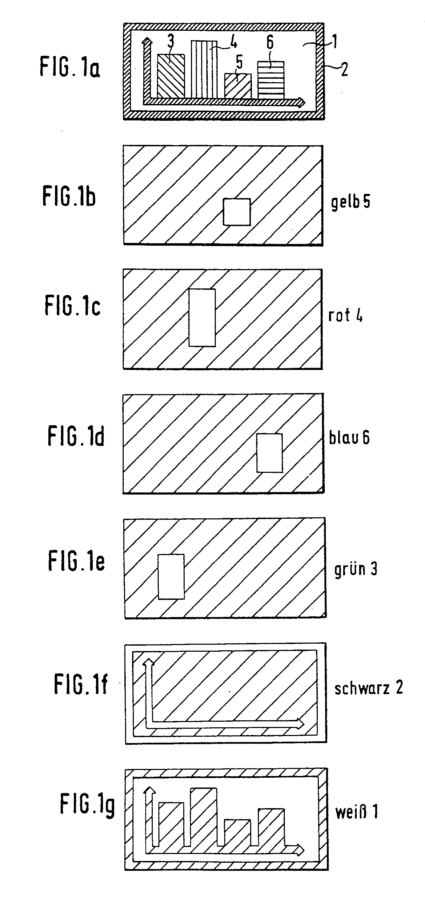

In Fig. 1a ist schematisch eine Beispiel graphisch dargestellt, in dem mit den Positionsnummern 1 bis 6 in der angeführten Reihenfolge die Teilbilder in den Farben weiß, schwarz, grün, rot, gelb und blau gekennzeichnet sind.

Es gibt verschiedene Möglichkeiten der Farbauszugsherstellung. Bei zeichnerischer Herstellung der Vorlage nach Fig. 1a können auf maßhaltigen Zeichenträgern wie Polyesterfolien den Farbauszügen entsprechende Teilbilder erstellt werden, die einzeln unter gleichen Aufnahmebedingungen photographiert werden.

Ebenso ist eine synthetische Herstellung möglich, worunter zu verstehen ist, daß Techniken wie Computerausdrucke graphischer Darstellungen oder elektronische Zeichentechniken verwendet werden.

Für die photographische Herstellung von Farbauszügen erfolgt im allgemeinen die Aufnahme der Farbauszüge mit komplementärfarbigem Licht auf panchromatischem Film, wobei die meistens großflächige Vorlage verkleinert wird. Üblicherweise werden Farbauszüge für die subtraktive Farbbildung hergestellt und zusätzlich ein Schwarzauszug angefertigt. Die subtraktive Farbbildung geschieht in der Weise, daß jeder Farbauszug in einer der Primärfarben als bildmäßiges Farbfilter arbeitet und die einzelnen Farbfilterbereiche einander überlagert sind.

Die additive Farbbildung erfolgt mit den vier Farben gelb, rot, blau und grün, die den sichtbaren Spektralbereich weitgehend lückenlos überdecken. Mischfarben werden durch die Verschachtelung verschiedenfarbiger Rasterelemente aus diesen vier primärfarben erzeugt, wobei die Farbintensität durch den Farbflächenanteil im Rasterelement dargestellt wird.

Diese Farbauszüge müssen durch geeignete Maskierung an die Aufzeichnungstechnik angepaßt werden. Außerdem wird noch win Weißauszug durch Aufnahme mit weißem Licht erstellt.

Die folgende Tabelle enthält die zu kombinierenden subtraktiven Farbauszüge. Ein "Negativ" ist dabei eine Aufnahme, auf der das Teilbild in einer Primärfarbe transparent ist, während bei einem "Positiv" die Aufnahme entspechend opak erscheint.

Mit den Primärfarben gelb, magenta und cyan werden die Farben gelb, rot, blau und grün dargestellt. Hinzu kommen noch die Auszüge für schwarz und weiß.

| Farbauszug | Überlagerung von Farbauszügen |
|---|---|
| Gelbauszug | Gelb—Negativ<br>Übrigen Farbauszüge—Positiv |
| Rotauszug | Magenta—Negativ<br>Übrigen Farbauszüge—Positiv |
| Blauauszug | Cyan—Negativ<br>Übrigen Farbauszüge—Positiv |
| Grünauszug | Gelb—Negativ<br>Cyan—Negativ<br>Übrigen Farbauszüge—Positiv |
| Schwarzauszug | Schwarz—Negativ<br>Übrigen Farbauszüge—Positiv |
| Weißauszug | Weiß—Negativ<br>Übrigen Farbauszüge—Positiv |

Der Grünauszug wird nicht direkt benötigt, wenn von einem ganzflächigen Reliefgitter mit rechteckförmigen Gitterprofilen einer Gittertiefe von 2,2 $\mu$m ausgegangen wird und durch Belichtung durch die anderen Farbauszüge hindurch die Gittertiefen für die anderen Farben erniedrigt werden; an den grünen Bildstellen bleiben dann die Gitterstege in unveränderter Höhe erhalten. Die Herstellung eines Grünauszuges wird jedoch für die in der Tabelle angegebenen Farbauszugskombinationen empfohlen.

Die Farbauszüge sind für gelb in Fig. 1b, für rot in Fig. 1c, für blau in Fig. 1d, für grün in Fig. 1e, für schwarz in Fig. 1f und für weiß in Fig. 1g schematisch dargestellt.

3

Zur Herstellung der Farbauszüge wird das wiederzugebende Bild in herkömmlicher Weise mit farbigem Licht als gerastertes Bild oder als Halbtonbild auf Silberfilm aufgenommen. Die vier Farbauszugsbelichtungen erfolgen mit Licht in den Wellenlängenbereichen 430—480 nm, 510—540 nm, 570—600 nm und 610—640 nm. Die Halbtonaufnahmen auf Silberfilm-Negativen oder -Positiven werden anschließend durch ein- oder zweimaliges Umkopieren durch ein Kontaktraster gerastert. Dabei ist es zur Kontraststeigerung von Vorteil, wen das Umkopieren auf ein sensitometrisch sehr hart arbeitendes Aufzeichnungsmaterial, beispielsweise aus Polyester/Aluminium/Kopierlack vorgenommen wird.

Bei jedem Farbauszug ist wesentlich, daß die Rasterpunkte an identischen Stellen relativ zum Bild positioniert sind und daß bei der paßgerechten Superposition aller Farbauszüge die Rasterpunkte sich nicht überlappen da jedes Rasterelement auf dem Gitterbild nur eine Farbinformation enthalten soll. Um die letztere Bedingung zu erfüllen, können beim Umkopieren durch ein Kontaktraster die Belichtungszeiten entsprechend verlängert oder verkürzt werden, wodurch in gewünschter Weise Rasterpunkte stärker oder schwächer abgebaut werden.

Weiße Bildstellen werden dadurch erhalten, daß bei allen Farbauszügen die entsprechenden Rasterelemente transparent sind, die daher bei jeder Belichtung durch einen Farbauszug bestrahlt werden. Infolge der dadurch bedingten Überbelichtung wird die Gitterstruktur so unterstrahlt und bei der Entwicklung so weit abgebaut, daß keine Farbe mehr bei der Projektion auftritt. Schwarze Bildstellen werden durch einen Schwarzauszug vor übermäßiger Belichtung während der Belichtung durch die anderen Farbauszüge geschützt. Dabei kann der Schwarzauszug gleichzeitig als Streufolie ausgebildet sein, so daß in der Projektion die betreffenden Bildstellen dunkel erscheinen.

Ein charakteristisches Merkmal dieser Farbauszüge, wodurch sie sich von denen für die subtraktive Farbbildung gererell unterscheiden, ist die vollständige Opazität bei der paarweisen Superposition. Dies ist beispielsweise bei der Überlagerung der Teilbilder nach den Fig. 1b und 1c oder den Figuren 1c und 1d, usw, ersichtlich. Beim paßgerechten Übereinanderlegen von je zwei Farbauszügen mit Hilfe von Paßstiften oder Paßmarken bleibt kein transparenter Bereich übrig, wodurch leicht, ohne besondere Hilfsmittel, überprüft werden kann, ob die Farbauszüge exakt hergestellt wurden.

Ein weiteres Merkmal für die richtige Gestaltung der Farbauszüge ist die vollständige Transparenz bei der Superposition aller Farbauszüge in zeitlicher Reihenfolge. Dieses Merkmal ist aus der Überlagerung der Teilbilder nach den Figuren 1b bis 1g ersichtlich. Ein einfaches Prüfverfahren besteht darin, nach der paßgerechten Auflage der Farbauszüge nacheinander auf ein lichtempfindliches Aufzeichnungsmaterial in Kontaktanordnung und erfolgter Belichtung zu prüfen, ob das Aufzeichnungsmaterial über die gesamte Bildfläche gleichmäßig belichtet ist. Das Prüfverfahren gestaltet sich leicht mit Diazotypiefilmen, die ein Arbeiten mit gelbem Sicherheitslicht zulassen. Die Belichtung muß hierbei mit UV-Licht erfolgen. Nach der Entwicklung mit Ammoniak muß der Diazotypiefilm farblos bleiben. Beim Entwickeln dunkel gewordene Stellen auf dem Diazotypiefilm zeigen eine fehlerhafte Gestaltung der Farbauszüge an.

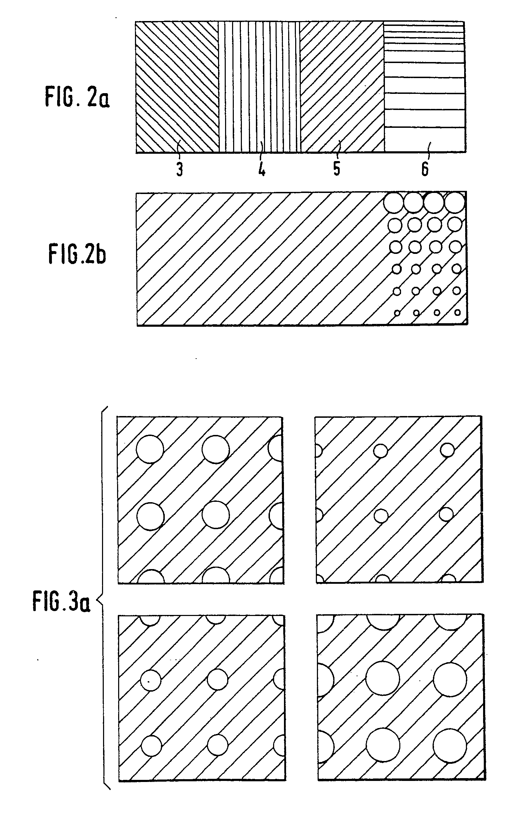

Die beiden charakteristischen Merkmale für geeignete Farbauszüge, nämlich vollständige Opazität bei jeweils paarweiser Superposition von Farbauszügen und vollständiger Transparenz bei der Superposition aller Farbauszüge in zeitlicher Reihenfolge, gelten auch für gerasterte Farbauszüge, unabhängig vom jeweiligen Herstellungsverfahren für die Farbauszüge. Im einfachsten Fall wird durch die Rasterung nur die Farbintensität reduziert, wie dies beispielsweise an der Vorlage gemäß Fig. 2a zu ersehen ist, die eine Intensitätsabnahme im Feld für die blaue Farbe 6 von blau über hellblau bis farblos bzw. weiß in Richtung von oben nach unten aufweist. Die Aufnahmen der Farbauszüge erfolgen wieder mit komplementärem Licht auf photographischem Film, wobei die Transparenz mit der Farbintensität zunimmt.

Die Maskierung kann in einer Reprokamera durch paßgerechte Überlagerung von Farbauszugstransparenten erfolgen, die bei gleichzeitiger Rasterung und im allgemeinen damit einhergehender Verkleinerung zusammen photographiert werden. Es wird ein Farbauszugspositiv für blau erhalten, das zu einem Farbauszugsnegativ umkopiert wird, wie es in Fig. 2b schematisch gezeigt ist. Entsprechend werden die Farbauszugstransparente für die anderen Farben hergestellt.

Damit die Rasterpunkte auf dem Reliefgitterbild auf farblosem Grund stehen und dadurch nur Abstufungen der Farbintensität wiedergeben, wird für den Weißauszug das folgende Herstellungsverfahren bevorzugt: In paßgerechter Kontaktbelichtung werden die Farbauszugsnegative, die auch gerastert sein können, für gelb, rot, blau, grün und schwarz nacheinander auf einen photographischen Film übertragen. Das entstandene Negativ stellt genau den gesuchten Weißauszug dar.

Beim Kopieren auf den leicht zu handhabenden Diazotypiefilm wird von den Farbauszugspositiven, die gleichfalls gerastert sein können, ausgegangen.

Im allgemeinen Fall enthalten die bunten Vorlagen Mischfarben, die durch geeignete Rasterung und Mischung von Rasterpunkten dargestellt werden können. Die Rasterpunkte der verschiedenen Farbauszüge dürfen sich jedoch nicht überlagern.

Farbauszüge mit einer derartigen Rasterstrukter können mit Hilfe von Farbabtastern durch bildpunktweises Abtasten der Vorlage und nachfolgende rechnerische Auswertung gewonnen werden. Dabei muß der Farbabtaster außer den Teilbildern für schwarz/weiß vier Farbteilbilder für die Spektralbereiche 430—480 nm, 510—540 nm, 570—600 nm und 610—640 nm aufnehmen oder, analog der Maskierungstechnik, die vier Farbteilbilder aus den drei Teilbildern für die subtraktive Farbdarstellung berechnen. Der nachgeschaltete Rechner muß für jeden Bildpunkt feststellen, welche der vier

4

benutzten Grundfarben grün, rot, gelb und blau zuzüglich weiß und schwarz überwiegt und wie groß die Farbintensität ist, damit ein Ausgabeelement, beispielsweise ein Lichtschreiber, entsprechend diesen Werten Rastersignalpunkte auf den Farbauszügen aufzeichnet.

Mit den nach dieser Technik hergestellten Farbauszügen werden farbige Projektionsbilder mit sensitometrisch harten Farbübergängen erhalten, die Mosaikdarstellungen ähnlich sind. Eine bessere Farbanpassung wird durch eine Mittelung über mehrere benachbarte Bildpunkte erzielt. Hierzu wird beispielsweise bei der Darstellung eines tiefblauen Himmels über einen gelben Untergrund zunächst gelb unterdrückt, weil nur Rastergrundsignale für blau ausgegeben werden. Die unterdrückten Gelbanteile werden vom Rechner gespeichert und dann in einer Weise ausgegeben, daß beispielsweise jeder dritte oder vierte Rasterpunkt dem Gelbauszug zugeordnet wird.

Geeignete Farbauszüge können auch ohen programmierbaren Farbabtaster hergestellt werden.

So ist eine Herstellung unter Verwendung von kostengünstigen, handelsüblichen Kontaktrasterfolien möglich. Kontaktrasterfolien mit periodischer Transmission von beispielsweise 48 Linien/mm oder 70 Linien/mm sind als Positiv-Kontaktraster auf dem Markt erhältlich. Eine solche Kontaktrasterfolie mit einfacher Periodizität, d. h. mit gleichartigen Rasterelementen, muß zuerst in der nachfolgend angegebenen Weise in Eine Rasterfolie von vierfacher Periodizität entsprechend den vier Grundfarben grün, rot, gelb und blau umgewandelt werden. Bei dieser umgewandelten Rasterfolie sind vier unterschiedliche Rasterelemente abwechselnd periodisch angeordnet. Schwarz und weiß werden nicht in diese periodische Struktur einbezogen, weil die in der Projektion schwarz erscheinenden Stellen als irreguläre Strukturen den periodischen Gitterstrukturen überlagert werden können und die weißen Bildstellen durch Ausbelichten gleichfalls den periodischen Gitterstrukturen überlagert werden können. Mit Hilfe einer Rasterfolie von vierfacher Periodizität ist eine Farbselektion für jeden Bildpunkt bei der Aufnahme von Farbauszügen möglich.

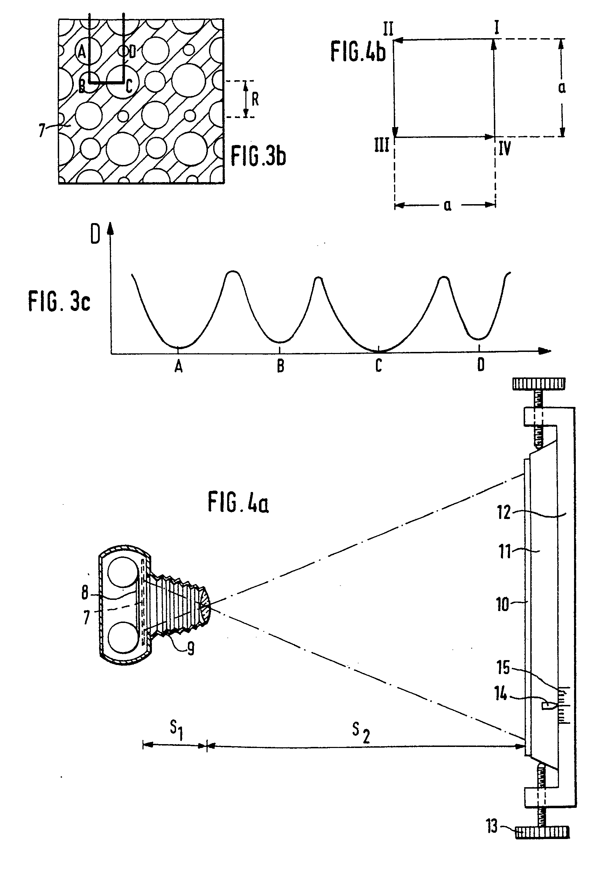

Zur Herstellung einer Rasterfolie vierfacher Periodizität werden zunächst von einer handelsüblichen einfachen Rasterfolie vier Kontaktkopien auf einem Aufzeichnungsmaterial angefertigt. Dabei werden die einzelnen Belichtungszeiten für die Kontaktkopien variiert, so daß vier in ihren Dichten und damit in den Rasterpunktöffnungen unterschiedliche Kontaktrasterkopien, wie sie in Fig. 3a schematisch dargestellt sind, erhalten werden. Diese Rasterfolien werden unter Versetzung sowohl in x- als auch in y-Richtung um jeweils eine halbe Rasterperiode auf ein Aufzeichnungsmaterial aufkopiert. Vorzugsweise wird ein sensitometrisch hart arbeitendes Aufzeichnungsmaterial benutzt. Gute Ergebnisse werden mit Diazotypiefilmen erzielt. Als Endprodukt wird eine Kontaktrasterfolie 7 mit vierfacher Periodizität aus vier in der Größe unterschiedlichen ineinander verschachtelten Rasterpunkten erhalten, wie sie schematisch in Fig. 3b dargestellt ist. Die optische Dichte D der Kontaktrasterfolie 7 längs eines Streckenzuges A—B—C—D ist in Fig. 3c aufgetragen.

Mit der Rasterfolie 7 vierfacher Periodizität können beliebig viele Farbauszugsaufnahmen angefertigt werden. Eine Anordnung dafür ist in Fig. 4a schematisch dargestellt.

Eine Kamera 9 mit einem photographischen Film 8 enthält in Kontaktanordnung die Kontaktrasterfolie 7 vierfacher Periodizität. Aufgenommen wird eine Vorlage 10, die auf einer verschiebbaren Filmbühne 11 aufliegt. Die Vorlage kann ein bereits maskierter, jedoch noch nicht gerasteter Farbauszugsfilm sein. In diesem Fall besteht die verschiebbare Filmbühne 11 aus einer in einem Rahmen gefaßten, rückseitig beleuchteten transparenten Mattscheibe. Die Filmbühne 11 ist in einem ortsfesten äußeren Rahmen 12 in einer Ebene parallel zu sich selbst in zwei zueinander senkrecht verlaufenden Richtungen verschiebbar, beispielsweise mit Hilfe von Stellschrauben 13, von denen nur zwei dargestellt sind. Eine oder mehrere Markierungen 14 auf der Filmbühne 11 sowie Skalen 15 auf dem äußeren Rahmen 12 dienen zur Positionierung der Filmbühne 11.

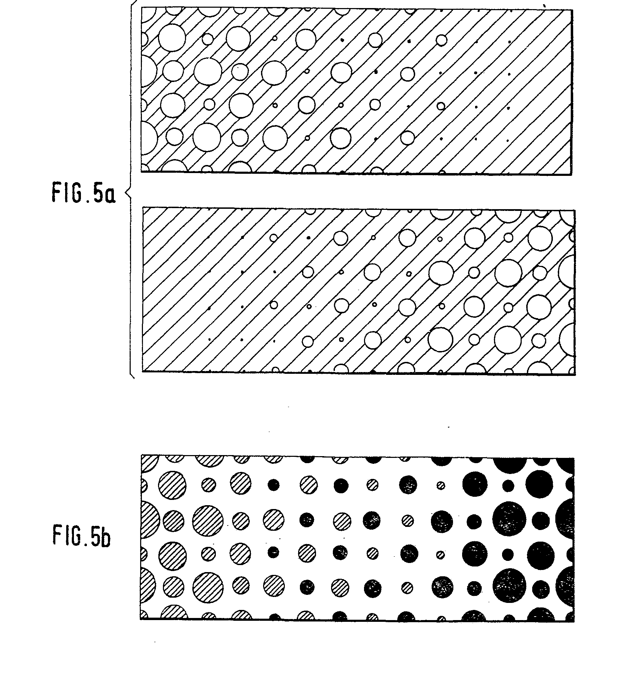

Bei der Aufnahme gerasteter Farbauszüge mit gleichzeitiger Verkleinerung auf dem Film 8 befindet sich die Vorlage 10 beispielsweise für die Aufnahme des Blauauszugs in der Position I in Fig. 4b. Für jede weitere Farbauszugsaufnahme fur andere Farben wird gemäß Fig. 4b die Position der paßgerechten, auf der Filmbühne 11 haftenden Vorlage 10 der Reihe nach in die Positionen II, III und IV um je eine Strecke a in einer geschlossenen Bahn zyklisch verschoben. Die Strecke a wird durch den Abbildungsmaßstab $S_2/S_1$, mit der Bildweite $S_1$ und der Gegenstandsweite $S_2$ und durch den in Fig. 3b eingezeichneten Rasterabstand R auf der Kontaktrasterfolie 7 gemäß der Beziehung $a=RS_2/S_1$ bestimmt. Bei einem Abbildungsmaßstab von beispielsweise 20:1 und einem Rasterabstand von 0,05 mm beträgt die Verschiebung a=1 mm, ein Wert, der ohne Schwierigkeiten einzustellen ist. Die Rasterfolie 7 bleibt bei den Aufnahmen ortsfest, so daß jeder Bildpunkt der Vorlage beiden verschiedenen Farbauszügen intensitätsmäßig unterschiedlich gewichtet wird. Es ist daher möglich, durch Variation der Belichtungszeiten bei der Aufnahme der gerasterten Farbauszüge kleine Rasterpunkte für Mischfarbendarstellungen gezielt zu unterdrücken. An deren Stelle tritt bei der farbauszugsweisen Belichtung der gittermäßig vorbelichteten Fotolackschicht ein Rasterpunkt eines anderen Farbteilbildes. Fig. 5a zeigt zei derart gerasterte Farbauszugsfolien für eine Farbübergang zwischen zwei Farben.

In Fig. 5b ist das Rastermuster auf einer Fotolackschicht nach der Belichtung durch die Farbauszugsfolien und durch den Weißauszug dargestellt.

Die Abstimmung der einzelnen Farbauszugstransparente untereinander sur Herstellung eines Reliefgitterbildes für ein buntes Projektionsbild bei Verwendung von Rasterfolien vierfacher Periodizität erfolgt durch die Belichtungszeiten bei der Herstellung der Farbauszugstransparente. Dabei müssen die Opazitäts- bzw. Transmissionsbedingungen erfüllt werden. Der Weißauszug wird vorzugsweise von der Kombination der anderen Farbauszugstransparente angefertigt. Selbst bei genauem Einhalten der Verfahrensschritte sind noch Verschiebungen der relativen Farbintensitäten möglich, die gezielt zur weitgehenden Farbanpassung des bunten Projektionsbildes an die bunte Vorlage genutzt werden können. Dies kann in der Weise erfolgen, daß unter positiven Farbauszugstransparenten Fotolackschichten mit aufbelichteten Gitterstrukturen für grün, rot, gelb und blau sowie mit irregulären Strukturen für schwarz belichtet und entwickelt werden. Bei paßgerechter Oberlagerung der bis zu fünf Folien mit farbigen Teilbildern kann anhand der davon erhältlichen bunten Projektionsbilder abgeschätzt werden, ob noch weitere Farbkorrekturen erforderlich sind oder nicht.

Für einfache Farbdarstellungen bereits ausreichende Ergebnisse werden erhalten, wenn von den beschriebenen Kontaktrasterfolien einfacher Periodizität ausgegangen wird und bei den Aufnahmen der Farbauszüge jeweils eine zyklische Verschiebung um einen halben Rasterpunktabstand vorgenommen wird. Die Rasterpunkte der anderen Farbauszüge werden dadurch jeweils zwischen zwei anderen Rasterpunkten positioniert. Wenn überdies die Fläche der Rasterpunkte durch Überbelichtung kleiner gehalten wird als die übliche Fläche der Rasterpunkte bei normaler Belichtung, d.h. die Zwischenräume der Rasterpunkte relative groß sind, passen die dazwischen gesetzten Rasterpunkte der anderen Farbauszüge überlappungsfrei in diese Zwischenräume.

Die Maßnahmen zur Herstellung von Farbauszugsfolien für farbige Reliefgitterbilder in einer Ebene müssen in Relation zu der Gesamtzahl der mit davon gefertigten Matrizen prägbaren Kopien von einigen hundert bis tausend Stück betrachtet werden. Es ist von Vorteil, den Aufwand an einer einzigen Stelle zu vergrößern, nämlich bei der Matrizenherstellung mit Hilfe der Farbauszugsfolien, um dafür den Vervielfältigungsprozeß mit der Massenproduktion von Kopien möglichst einfach ausführen zu können. Dieser verfahrenstechnische Vorteil überwiegt bei einem Vergleich mit der subtraktiven Farbbildung eventuelle kleine Abstriche in der Farbqualität bei weitem. Hinzu kommt noch, daß bei einschichtigen Reliefbildern, die mit Hilfe der erfindungsgemäßen Farbauszugsfolien hergestellt wurden, die weißen bzw. farblosen Teilbilder heller und störstellenärmer sind als bei mehrschichtigen Reliefbildern, da bei der überlagerung mehrerer Folien Störungen durch beispielsweise Kratzer und Staub sowie Lichtverluste durch Reflexionen an den zahlreichen Folien sich summieren.

**Patentansprüche**

1. Farbauszugstransparent für eine bestimmte, aus den Primärfarben blau, grün, gelb, rot, bzw. den Farben weiß und schwarz oder den Mischfarben ausgewählte Farbe, dadurch gekennzeichnet, daß ein Teilbild in der jeweiligen gewählten Farbe vorhanden ist, daß das Farbauszugstransparent in den Flächenbereichen transparent ist, welche die ausgewählte Farbe wiedergeben, daß die außerhalb des Teilbildes liegenden Flächen des Farbauszugstransparents opak sind, und daß das Teilbild derart gerastert ist, daß es eine Anzahl von Rasterelementen aufweist, deren mittlerer Abstand voneinander in jedem Bildbereich der mittleren Farbdichte in diesem Bildbereich entspricht.

2. Farbauszugstransparent nach Anspruch 1, dadurch gekenneichnet, daß die Rasterung des Teilbildes aus sich periodisch wiederholenden Einheiten aus Rasterelementen besteht, daß jede Einheit eine Anordnung von mehr als zwei sich nicht überlagernden Rasterelementen umfaßt, die jeweils einen Abstand voneinander besitzen, der sich von demjenigen der anderen Rasterelemente unterscheidet, und daß die Anordnung der Rasterelemente in allen Einheiten dieselbe ist.

3. Farbauszugstransparent nach den Ansprüchen 1 und 2, dadurch gekennzeichnet, daß für jede der Primärfarben eine Rasterung mit gleichartigen Rasterelementen in einfacher Periodizität aufgebracht ist.

4. Farbauszugstransparent nach den Ansprüchen 1 und 2, dadurch gekennzeichnet, daß für eine Mischfarbe eine Rasterung mit Rasterelementen, die sich in ihren Dichten und in ihren Rasterelementabständen voneinander unterscheiden, in mehrfacher Periodizität aufgebracht ist.

5. Farbauszugstransparent nach Anspruch 4, dadurch gekennzeichnet, daß die voneinander verschiedenen Rasterelemente ohne Überlagerung aufgebracht sind.

6. Farbauszugstransparent nach Anspruch 4, dadurch gekennzeichnet, daß eine Rasterung mit Rasterelementen in vierfacher Periodizität aufgebracht ist.

7. Farbauszugstransparent nach Anspruch 4, dadurch gekennzeichnet, daß die voneinander verschiedenen Rasterelemente zyklisch längs eines geschlossenen Linienzuges zueinander um jeweils eine Rasterperiode versetzt aufgebracht sind.

8. Farbauszugstransparent nach Anspruch 3, dadurch gekennzeichnet, daß die gleichartigen Rasterelemente zyklisch längs eines geschlossenen Linienzuges zueinander um jeweils eine halbe Rasterperiode versetzt aufgebracht sind.

9. Verfahren zur Herstellung eines Farbauszugstransparents für eine Farbe nach den Ansprüchen 1 bis 8 von einer Vorlage, dadurch gekennzeichnet, daß die Vorlage mit Licht der Komplemertärfarbe zu der gewünschten Primärfarbe des Farbauszugs auf einen fotografischen Film aufbelichtet wird, um ein Farbauszug-Positive zu erhalten, daß das Farbauszug-Positiv auf einen Negativfarbfilm umkopiert wird, um ein Farbauszug-Negativ zu erhalten, in dem das Teilbild in der Primärfarbe, bis auf eine Rasterung, transparent und die übrigen Bildbereiche opak sind, und daß entweder der fotografische Film oder der Negativfarbfilm durch eine Rasterung hindurch belichtet wird, die aus einer Anzahl gleichartiger, sich periodisch wiederholender Einheiten von Rasterelementen verschiedenen Abstandes und gleicher Periode besteht, so daß das Teilbild im Farbauszug-Negativ eine Anzahl von Rasterelementen enthält.

10. Verfahren zur Herstellung eines Farbauszugstransparents für eine Farbe nach den Ansprüchen 1 bis 8 mit Hilfe der Farbauszüge für cyan, magenta und gelb, dadurch gekennzeichnet, daß das Farbauszugstransparent für eine der gewünschten Primärfarben durch Aufbelichten des Farbauszug-Negatives für gelb, magenta, cyan oder der paßgenau aufeinanderliegenden Farbauszug-Negative für gelb und cyan, denen jeweils die Farbauszug-Positive der übrigen Farben unter Einschluß der Positive für schwarz und weiß paßgenau überlagert sind, erhalten wird.

11. Verfahren nach Anspruch 10, dadurch gekennzeichnet, daß die Farbauszug-Negative für die Farben gelb, rot, blau, grün und schwarz nacheinander im paßgerechten Kontakt auf einen fotografischen Film aufbelichtet werden, um das Farbauszug-Negativ für die Farbe weiß zu erhalten.

12. Verfahren zur Herstellung eines Farbauszugstransparents nach einem oder mehreren der Ansprüche 1 bis 8 von einer Mischfarben aufweisenden Vorlage, dadurch gekennzeichnet, daß die Vorlage bildpunktweise in den Spektralbereichen für blau, grün, gelb und rot abgetastet wird, daß die Teilbilder der Vorlage für die Farben weiß und schwarz bestimmt werden, daß die Farbwerte für die abgetasteten Bildpunkte gespeichert werden und daraus berechnet wird, welche Farbe in jedem Bildpunkt überwiegt und wie groß die Farbintensität ist und daß entsprechend den Werten für die jeweilige dominante Farbe in den Bildpunkten die Aufzeichnung der zugehörigen Rastersignalpunkte auf dem Farbauszugstransparent mit einem Lichtschreiber, der den fotografischen Film entsprechend der jeweiligen Farbintensität schwärzt, gesteuert wird.

13. Verfahren nach Anspruch 12, dadurch gekennzeichnet, daß zur Farbabstimmung in einem Rasterpunkt bei der Abtastung der Vorlage, über mehrere benachbarte Bildpunkte, die dem Rasterpunkt zugeordnet sind, in der Weise gemittelt wird, daß zunächst nur Rastergrundsignale für eine bestimmte Farbe ausgegeben werden, während die übrigen Farben gespeichert und ihre Signalwerte in festgelegter Reihenfolge als Rasterpunkte dem jeweiligen zugehörigen Farbauszug zugeordnet und ausgegeben werden.

14. Verfahren nach den Ansprüchen 10 und 11, dadurch gekennzeichnet, daß eine Rasterung des Farbauszugstransparents mit mehrfacher Periodizität entsprechend mehreren Farben in der Weise vorgenommen wird, daß von einer Rasterfolie einfacher Periodizität eine Anzahl von Rasterkopien in Kontaktanordnung, deren Anzahl der Anzahl der Farben entspricht, auf einem Aufzeichnungsmaterial mit unterschiedlichen Belichtungszeiten für die einzelne Rasterkopie angefertigt wird und daß diese Rasterkopien auf ein Aufzeichnungsmaterial unter Versetzung zueinander aufkopiert werden.

15. Verfahren nach Anspruch 14, dadurch gekennzeichnet, daß ein lichtempfindlicher Film durch ein ortsfestes, gerastertes Farbauszugstransparent mehrfacher Periodizität hindurch belichtet wird und daß eine bewegliche Vorlage für jede Farbe zyklisch längs einer geschlossenen Bahn jeweils um eine Strecke versetzt wird, die dem Produkt aus Abbildungsmaßstab und Rasterabstand R auf dem gerasterten Farbauszugstransparent entspricht.

## Claims

1. A color separation transparency of one color, selected from the primary colors blue, green, yellow or red or the colors black and white or the secondary colors thereof, characterized in that there is a partial image in said one color; that said color separation transparency is transparent in the areas representing said one color; that the areas of the color separation transparency outside the part image are opaque; and that said partial image is screened such that it comprises a plurality of screen dots, the average apertures of said screen dots in each portion of said image corresponding approximately to the average density of said color in said image portion.

2. A color separation transparency as claimed in Claim 1, characterized in that said part image is screened such that it is composed of periodically repeating units of screen dots; that each unit comprises an array of more than two non-overlapping screen dots, each having an aperture different from the aperture of the other screen dots; and that the arrangement of the screen dots in all of said units is identical.

3. A color separation transparency as claimed in Claims 1 and 2, wherein for each of the primary colors the screening comprises screen elements of the same type of single periodicity.

4. A color separation transparency as claimed in Claims 1 and 2, wherein the screening for a secondary color comprises a multiple periodicity, with screen elements which are distinguished from one another by their densities and their screen dot apertures.

5. A color separation transparency as claimed in claim 4, wherein the screen elements which differ from one another are applied without overlap.

6. A color separation transparency as claimed in Claim 4, wherein the screening comprises screen dots in a four-fold periodicity.

7. A color separation transparency as claimed in Claim 4, wherein the screen dots which are different from one another are mutually offset by one screen period in each case, cyclically along a closed series of lines.

8. A color separation transparency as claimed in Claim 3, wherein the screen elements of the same type are mutually offset by half a screen period in each case, cyclically along a closed series of lines.

9. A process for the preparation of a color separation transparency for one color as claimed in Claims 1 through 8 from an original, characterized in that the original is exposed to a photographic film with light of the color complementary to the desired primary color of the color separation to produce a color separation positive; that the resulting color separation positive is reprinted to a negative color film to obtain a color separation negative wherein the partial image in the primary color, apart from a screen, is transparent and the remaining image areas are opaque; and that either the photographic film or the negative color film is exposed through a screen comprsing a plurality of identical periodically repeating units of screen dots of different aperture and constant period, such that the image in the color separation negative comprises a plurality of screen dots.

10. A process for the preparation of a color separation transparency for one color as claimed in Claims 1 through 8 by means of the color separations for cyan, magenta and yellow, wherein the color separation transparency for one of the desired primary colors is obtained by exposing the color separation negative for yellow, magenta, cyan or the color separation negatives for yellow and cyan, which are superposed in true register, to which the color separation positives of the remaining colors including the positives for black and white, are each time superposed in true register.

11. A process as claimed in Claim 10, wherein the color separation negatives for the colors yellow, red, blue, green and black are successively exposed, in true register, in contact to a photographic film, in order to obtain the color separation negative for the color white.

12. A process for the preparation of a color separation transparency, as claimed in one or more of Claims 1 to 8, from an original containing secondary colors, which comprises scanning the original by image dots in the spectral ranges for blue, green yellow and red, determining the part images of the original for the colors white and black, storing the color values for the scanned image dots and computing therefrom that color, which predominates at each image dot, and the magnitude of the color intensity, and controlling the recording of the associated screen signal dots on the color separation transparency corresponding to the values of the particular dominant color at the image dots by use of a light recorder by which the photographic film is blackened in accordance with the individual color intensity.

13. A process as claimed in claim 12, which comprises, for color adaptation in one screen dot when scanning the original, taking an average over several adjacent image dots associated with the screen dot, in such a way that initially only screen ground signals for a certain color are given as output, while the remaining colors are stored and their signal values are allocated in a fixed order as screen dots to the particular associated color separation and given as output.

14. A process as claimed in Claims 10 and 11, which comprises carrying out the screening of the color separation transparency with a multiple periodicity, corresponding to several colors, in such a way that a number of screen copies, their number corresponding to the number of colors, is produced in contact arrangement on a recording material from a screen film of single periodicity, with different exposure times for the individual screen copy and that these screen copies are copied with a mutual offset onto a recording material.

15. A process as claimed in claim 14, which comprises exposing a light-sensitive film through a stationary screened color separation transparency of multiple periodicity and offsetting a movable original for each color cyclically along a closed path in each case by a length which corresponds to the product of the image scale and of the screen spacing R on the screened color separation transparency.

## Revendications

1. Cliché transparent de sélection de couleurs permetant de sélectionner une couleur déterminée parmi les couleurs de base bleue, verte, jaune, rouge, voire le blanc et le noir ou encore parmi les couleurs mélangées, caractérisé en ce que l'on dispose d'une image partielle pour chacune des couleurs sélectionnées, en ce que le cliché de sélection est transparent dans les zones qui reflètant la couleur sélectionée, en ce que les zones du cliché de sélection situées en dehors de l'image partielle sont opaques, et en ce que l'image partielle est tramée de manière que les éléments de tramage soient disposés dans chacune des zones d'image de manière que l'intervalle moyen séparant ces éléments de tramage corresponde à la densité moyenne de la couleur dans cette zone.

2. Cliché transparent de sélection de couleurs selon la revendication 1, caractérisé en ce que le tramage de l'image partielle se compose d'un certain nombre d'unités constituées d'éléments de tramage se répétant périodiquement, en ce que chaque unité comporte un ensemble de plus de deux éléments de tramage qui ne se recouvrent pas et qui sont séparés entre eux par un intervalle qui diffère des intervalles des autres éléments et en ce que la disposition de ces éléments est la même dans toutes les unités.

3. Cliché transparent de sélection de couleurs selon la revendication 1 ou 2, caractérisé en ce que

# 0 006 504

pour chacune des couleurs de base on applique un tramage comportant des éléments de tramage identiques en périodicité simple.

4. Cliché transparent de sélection de couleurs selon les revendications 1 et 2, caractérisé en ce que pour une couleur mélangée l'on applique un tramage comportant des éléments de tramage en périodicité multiple, qui diffèrent entre eux par leur densité et par l'intervalle qui les sépare.

5. Cliché transparent de sélection de couleurs selon la revendication 4, caractérisé en ce que les éléments de tramage qui diffèrent entre eux sont appliqués sans se superposer.

6. Cliché transparent de sélection de couleurs selon la revendication 4, caractérisé en ce que l'on utilise un tramage composé d'éléments en périodicité quadruple.

7. Cliché transparent de sélection de couleurs selon la revendication 4, caractérisé en ce que les éléments du tramage, qui diffèrent entre eux, sont appliqués d'une manière cyclique le long d'un tracé fermé et sont décalés, à chaque fois, d'une période de tramage, les uns par rapport aux autres.

8. Cliché transparent de sélection de couleurs selon la revendication 3, caractérisé en ce que les éléments de tramage identiques sont appliqués d'une manière cyclique le long d'un tracé fermé et sont décalés, à chaque fois, d'une demi-période de tramage les uns par rapport aux autres.

9. Méthode pour la préparation d'un cliché transparent de sélection d'une couleur selon l'une quelconque des revendications 1 à 8, caractérisée en ce que le document original est insolé avec une lumière de la couleur complémentaire à la couleur de base déterminée et enregistré ainsi sur un film photographique en vue d'obtenir ainsi un extrait de couleur positif, en ce que cet extrait de couleur positif est recopié sur un film négatif en vue d'obtenir un extrait de couleur négatif sur lequel l'image partielle est transparente dans la zone de la couleur de base, à l'exception d'une trame, alors que les autres zones de l'image sont opaques et en ce que soit le film photographique, soit le film négatif est insolé à travers une trame constituée d'un certain nombre d'unités de tramage identiques se répétant périodiquement, accusant des intervalles différents et une même période, ce qui fait que l'image partielle de l'extrait de couleur négatif comporte un certain nombre d'éléments de tramage.

10. Méthode pour la préparation d'un cliché transparent de sélection d'une couleur selon l'une quelconque des revendications 1 à 8 et à l'aide des extraits de couleur pour le bleu cyanique, le magenta et le jaune, caractérisée en ce que le cliché transparent de sélection de couleurs et obtenu, pour l'une des couleurs de base déterminée, soit en insolant l'extrait de couleur négatif du jaune, du magenta et du bleu cyanique sur lequel l'on place, chaque fois, les extraits de couleur positifs superposés d'une manière correctement ajustée, des autres couleurs y compris les positifs du noir et du blanc.

11. Méthode selon la revendication 10, caractérisée en ce que les extraits de couleur négatifs des couleurs jaune, rouge, bleue, verte et noire sont enregistrés successivement, en contact correctement adjusté, sur un film photographique en vue d'obtenir ainsi l'extrait de couleur négatif de la couleur blanche.

12. Méthode pour la préparation d'un cliché transparent de sélection de couleurs selon l'une quelconque des revendications 1 à 8 et à partir d'un document original comportant des couleurs mélangées, caractérisée en ce que le document original est balayé, élément d'image par élément d'image, dans la gamme spectrale du bleu, du vert, du jaune et du rouge, en ce que les images partielles du document original sont déterminées en fonction des couleurs blanche et noire, en ce que les valeurs des couleurs concernant les éléments d'images balayés sont mémorisées dans un ordinateur qui calcule, à partir de ces données, la couleur dominante dans chacun de ces éléments d'image, ainsi que l'intensité des couleurs et en ce que, en fonction de chacune de ces valeurs dominantes, un marqueur électronique trace dans les éléments d'images les signaux des points de trame sur le cliché transparent de sélection des couleurs et noircit le film photographique en fonction de l'intensité calculée des couleurs.

13. Méthode selon la revendication 12, caractérisée en ce que pour harmoniser les couleurs dans un point de trame au moment où le document original subit le balayage d'un certain nombre d'éléments d'images voisins, coordonnés à ce point de trame, il est procédé de manière que dans un premier temps ne sont émis que des signaux de base de la trame d'une couleur déterminée, alors que les valeurs des autres couleurs sont mémorisées pour n'être émises qu'après avoir été coordonnées, dans un ordre chronologique déterminé et sous forme de points de trame, à l'extrait de couleur correspondant.

14. Méthode selon les revendications 10 et 11, caractérisée en ce que le tramage du cliché transparent de sélection des couleurs à périodicité multiple et correspondant à plusieurs couleurs est effectué de manière que, partant d'une feuille tramée de périodicité simple, l'on effectue sur un matériel d'enregistrement approprié et par le procédé de contact, un nombre de copies de la trame égal au nombre de couleurs en faisant varier le temps d'insolation pour chacune des copies de la trame et en ce que ces copies de la trame sont recopiées sur un matériel d'enregistrement en les décalant les unes par rapport aux autres.

15. Méthode selon la revendication 14, caractérisée en ce qu'un film photosensible est insolé à travers un cliché transparent de sélection de couleurs tramé et fixe à périodicité multiple et en ce qu'un document original mobile est déplacé d'une manière cyclique le long d'un tracé fermé et pour chacune des couleurs sur une distance égale au produit du rapport de reproduction par le pas R de la trame du cliché transparent de sélection tramé.

FIG.1a

FIG.1b                                            gelb 5

FIG.1c                                            rot 4

FIG.1d                                            blau 6

FIG.1e                                            grün 3

FIG.1f                                            schwarz 2

FIG.1g                                            weiß 1

FIG. 2a

FIG.2b

FIG.3a

FIG.3b

FIG.4b

FIG. 3c

FIG.4a

FIG.5a

FIG.5b